# FASCICULE DE BREVET EUROPEEN

(11) **EP 2 791 048 B1**
(45) Date de publication et mention de la délivrance du brevet: **09.01.2019**
(21) Numéro de dépôt: 12806423.5
(22) Date de dépôt: 12.12.2012
(51) Int. Cl.: B81B 3/00

(54) **LIAISON MECANIQUE FORMANT PIVOT POUR STRUCTURES MECANIQUES MEMS ET NEMS**
MECHANISCHE VERBINDUNG ZUR FORMUNG EINER GELENKVORRICHTUNG FÜR MECHANISCHE MEMS- UND NEMS- STRUKTUREN
MECHANICAL CONNECTION FORMING A PIVOT FOR MEMS AND NEMS MECHANICAL STRUCTURES

(30) Priorité: 12.12.2011 FR 1161487
(43) Date de publication de la demande: 22.10.2014
(73) Titulaire: COMMISSARIAT À L'ÉNERGIE ATOMIQUE ET AUX ÉNERGIES ALTERNATIVES, 75015 Paris (FR)
(72) Inventeur: JOURDAN, Guillaume, F-38000 Grenoble (FR); ETTELT, Dirk, 45892 Gelsenkirchen (DE); REY, Patrice, F-38430 St Jean De Moirans (FR); WALTHER, Arnaud, F-38000 Grenoble (FR)
(74) Mandataire: Brevalex
(86) Numéro de dépôt international: PCT/EP2012/075278
(87) Numéro de publication internationale: WO 2013/087717

(56) Documents cités:
- US-A- 5 629 794
- US-A1- 2010 017 923
- US-B1- 6 360 035
- US-B1- 6 392 220

## Description

### DOMAINE TECHNIQUE ET ART ANTÉRIEUR

La présente invention se rapporte à une liaison mécanique formant pivot pour structure MEMS (« microelectromechanical systems » en terminologie anglaise) et NEMS (« nanoelectromechanical systems » en terminologie anglaise) entre deux parties aptes à pivoter l'une par rapport à l'autre.

Dans l'état de la technique, il existe deux solutions techniques pour réaliser une liaison pivot dans les structures MEMS et NEMS.

La première solution met en oeuvre des poutres reliant par exemple la partie fixe et la partie mobile et travaillant en flexion. Les poutres sont disposées parallèlement les unes par rapport aux autres, et l'axe de la liaison pivot est orthogonal à l'axe des poutres.

La deuxième solution met en oeuvre des poutres alignées, par exemple au nombre de deux, reliant la partie fixe et la partie mobile, et travaillant en torsion. L'axe de la liaison pivot est confondu avec l'axe des poutres.

Les structures MEMS et NEMS, par exemple utilisées comme gyromètre ou accéléromètre, utilisent la partie mobile comme moyen de détection, celle-ci étant mise en mouvement par une force de Coriolis ou une accélération respectivement.

Ces structures peuvent subir des perturbations mécaniques de plusieurs types.

Le premier type de perturbation est le choc inertiel : un choc génère sur la structure MEMS une force inertielle de grande intensité : la plupart des cahiers des charges des capteurs MEMS ou NEMS exige une résistance à des chocs de 10000 g (1g = 9,8 m/s²). D'un point de vue mécanique, l'effort résultant sur la structure est une force pure, i.e. sans moment, appliquée sur le centre d'inertie de la structure et d'intensité F = ma, m étant la masse et a, l'accélération. Ramené sur l'axe de rotation de la liaison pivot des moments importants peuvent également être générés.

Le deuxième type de perturbation est le choc magnétique : un magnétomètre MEMS ou NEMS possède un élément mobile qui peut être mis en mouvement par un champ magnétique B. L'élément mobile peut être composé d'un matériau magnétique de moment d'aimantation M. En présence d'un champ B, un moment mécanique est généré et est égal à M × B. Si le champ magnétique est de forte intensité, l'effort mécanique peut endommager la structure MEMS.

Le troisième type de perturbation est le mouvement parasite : un capteur MEMS ou NEMS quelconque est soumis à des forces inertielles lorsque le capteur est en mouvement non uniforme. Ces forces peuvent générer des mouvements non souhaités de la structure MEMS ou NEMS. Ceux-ci peuvent produire un signal parasite dans le signal de mesure du capteur, par exemple une sensibilité d'un magnétomètre ou d'un capteur de pression à une accélération, une sensibilité croisée, etc.

Or, une liaison pivot formée par des poutres de flexion ou des poutres de torsion, ne permet pas de réduire toutes les amplitudes des mouvements de translation selon les trois directions de l'espace et les mouvements de rotation autour des directions orthogonales à l'axe de la liaison pivot. En d'autres termes, une liaison pivot formée exclusivement par l'un ou l'autre type de poutre n'assure pas des raideurs importantes selon ces degrés de liberté.

En outre, la miniaturisation des systèmes MEMS et NEMS conduit à l'utilisation de poutres de liaison de plus en plus petites afin de conserver des liaisons cinématiques performantes entre les différents éléments du système. Cependant, la réduction des sections transverses de ces poutres diminue fortement leurs raideurs transverses. Les sensibilités en déplacement, qui sont proportionnelles à l'inverse de la raideur 1/k selon les directions transverses, deviennent alors dans ces conditions plus importantes.

Ces déplacements parasites peuvent se manifester dans le signal délivré par le capteur. Par exemple, si les moyens de détection sont de type capacitif comprenant une électrode mobile attachée à la structure mobile et une électrode attachée à la structure fixe, dans le cas le plus général, la capacité dépend de tous les degrés de liberté.

Des méthodes de mesure permettent de réduire ce signal parasite grâce à la mise en place par exemple de ponts de capacités de dépendances opposées, cependant les méthodes de mesure sont rendues plus complexes.

Par ailleurs, des jauges de contrainte peuvent être intégrées au système afin de détecter le mouvement entre les deux structures. Celles-ci ont des dimensions inférieures à celles des poutres et peuvent présenter des raideurs mécaniques plus importantes que pour les poutres formant la liaison pivot, en raison de leurs longueurs largement plus petites. Une raideur longitudinale importante est en effet recherchée afin de s'opposer au mouvement de rotation de la liaison pivot : la contrainte générée dans les jauges est de cette manière proportionnelle au mouvement de rotation. Ces raideurs importantes selon les trois directions peuvent poser problème en cas de choc, car ce sont justement les éléments présentant les raideurs les plus importantes qui s'opposent aux forces générées par le choc : il en résulte un risque accru de dégradation des jauges et des éléments de liaison de dimensions inférieures à celles de poutres formant le pivot, et donc un risque accru de la dégradation du MEMS ou NEMS.

Les jauges de contraintes sont disposées perpendiculairement à l'axe de rotation de la liaison pivot. En raison de leurs fortes raideurs longitudinale et transverse, les jauges peuvent bloquer les mouvements parasites, cependant elles peuvent être en contre partie soumises à des efforts importants et destructibles. Par exemple, en cas de choc inférieur à 10000g, qui est une valeur habituellement utilisée, les jauges pourraient être endommagées et par conséquent le système deviendrait hors service.

Afin de résoudre ce problème de la résistance aux chocs, une solution consiste à graver des butées à proximité des pièces mobiles, à proximité des zones de la structure qui présentent les plus grandes amplitudes de déplacement. Ces dernières ont pour fonction de bloquer le plus rapidement possible le mouvement généré par le choc mécanique : une fois la pièce bloquée, les efforts générés sur les éléments mécaniques fragiles, tels que les jauges, sont répartis et augmentent très faiblement. Un dimensionnement doit être réalisé au cas par cas pour s'assurer de la résistance de la structure aux chocs. Cependant, cette solution ne permet pas en toute circonstance de répondre au problème posé. Les mouvements réalisés au moment de la dégradation peuvent avoir des amplitudes largement inférieures au micromètre, qui est la limite en dessous de laquelle la gravure des espacements entre la butée et la structure mobile devient difficile.

Le document US 6360035 décrit un microinterrupeur optique comportant une liaison mécanique dans lequel l'axe de rotation est défini par l'axe de torsion des articulations.

### EXPOSÉ DE L'INVENTION

C'est par conséquent un but de la présente invention d'offrir une liaison pivot pour structures MEMS et NEMS permettant la réalisation de structures MEMS et NEMS robustes aux perturbations mécaniques.

Un structure selon la présente invention est défini dans la revendication 1.

Le but de la présente invention est atteint par une liaison mécanique entre une première partie et une deuxième partie, la deuxième partie étant destinée à pivoter par rapport à la première partie autour d'un axe de rotation, la liaison comportant au moins une première et une deuxième poutres dont les axes sont sécants et définissant un axe de pivot résultant présentant une rigidité augmentée dans le plan de la structure.

Dans un mode de réalisation, la première poutre est parallèle à l'axe de rotation et s'étend entre la première partie mobile et la deuxième partie et au moins une deuxième poutre est perpendiculaire à l'axe de rotation et s'étend entre la première partie et la deuxième partie mobile. La première poutre travaille en torsion et la deuxième poutre travaille en flexion.

La combinaison de ces deux types de poutre offre des raideurs importantes en translation le long de trois directions de l'espace et une raideur importante en rotation autour des deux directions de l'espace différentes de celle de l'axe de rotation. En cas de choc, les jauges de contrainte sont alors protégées. Et cette combinaison de poutre permet d'obtenir une forte sensibilité à la grandeur mesurée.

La liaison mécanique proposée permet, d'une part de réduire l'amplitude des mouvements de translation non désirés et des mouvements de rotation autour des axes autres que celui de la liaison pivot, ce qui permet donc de rendre moins sensible la structure mécanique à d'autres sources potentielles de perturbations extérieures, comme par exemple une accélération pour un magnétomètre ou une force inertielle d'un axe transverse dans le cas d'un accéléromètre, ces mouvements non désirés pouvant être responsables de sensibilités croisées dans un accéléromètre.

D'autre part, cette liaison mécanique confère au système une résistance aux chocs mécaniques plus importante. Cette propriété de la liaison mécanique est très intéressante dans le domaine des capteurs de type inertiel qui nécessitent de conserver des masses importantes pour garder de fortes sensibilités, mais dont on cherche à miniaturiser les éléments de liaison, qui deviennent plus fragiles. Les éléments de liaisons mécaniques plus fragiles, tels des nano jauges de contraintes, sont alors protégés du fait de la raideur importante de la liaison pivot selon les 5 autres degrés de liberté complémentaires selon l'invention. Dans l'état de la technique, c'étaient les jauges de contraintes qui présentaient la plus grande raideur et ce sont elles qui supportaient ces chocs mécaniques.

En d'autres termes, l'axe pivot de la liaison mécanique résulte de l'axe de rotation d'au moins une poutre travaillant en torsion et de l'axe de rotation défini par au moins une poutre travaillant en flexion.

Dans le premier mode de réalisation, de préférence, l'axe de rotation formé par la au moins une poutre travaillant en torsion et l'axe de rotation formé par la au moins une poutre travaillant en flexion sont confondus. Pour cela, au moins un ancrage de la poutre de torsion à la partie fixe et/ou mobile est situé à proximité du centre de la poutre de flexion.

La présente invention a alors pour objet une liaison mécanique entre deux parties d'une structure microélectromécanique et/ou nanoélectromécanique formant un pivot d'axe de rotation comportant au moins une première poutre disposée parallèlement à l'axe de pivot, ladite première poutre étant destinée à travailler en torsion et au moins une deuxième poutre d'axe orthogonal à l'axe de la première poutre, ladite deuxième poutre étant destinée à travailler en flexion, chacune des première et deuxième poutres étant reliées au niveau de leurs extrémités aux deux parties de la structure de sorte à permettre auxdites parties de se déplacer en rotation selon ledit axe pivot et à éviter auxdites parties de se déplacer en translation selon cet axe, dans laquelle la première poutre travaille en torsion selon un premier axe de rotation et la deuxième poutre travaille en flexion définissant un deuxième axe de rotation, et dans laquelle l'axe pivot de ladite liaison mécanique résulte du premier axe et du deuxième axe et est parallèle aux premier et deuxième axes.

On entend par "éviter de se déplacer en translation ou en rotation" une réduction par un facteur supérieur à deux de l'amplitude des déplacements (translation ou rotation) des parties A par rapport au partie B lorsque la liaison selon l'invention est mise en oeuvre par rapport à l'amplitude que l'on obtiendrait en ne considérant qu'un seul type de poutres (torsion ou flexion) pour un même effort mécanique exercé en considérant soit l'absence soit la présence de jauges de contrainte.

Le décalage des axes de rotation définis pour chaque type de poutre (flexion ou torsion) se situe de préférence dans une gamme à l'intérieur de laquelle l'angle de rotation de la partie mobile A par rapport à la partie fixe B obtenu avec la liaison selon l'invention est supérieur à 1% du minimum des angles de rotation que l'on obtiendrait en ne conservant qu'une seul type de poutre pour un même effort mécanique exercé en l'absence de jauges de contrainte en considérant soit la présence soit l'absence de jauges de contrainte.

Chacune des première et deuxième poutres sont reliées au niveau de leurs extrémités aux deux parties de la structure de sorte à éviter avantageusement auxdites parties de se déplacer en rotation en dehors dudit axe pivot.

Selon une caractéristique de l'invention, la première poutre travaille en torsion selon un premier axe de rotation et la deuxième poutre travaille en flexion définissant un deuxième axe de rotation, l'axe pivot de ladite liaison mécanique résultant du premier axe et du deuxième axe et étant parallèle au premier et deuxième axe.

De préférence, le premier axe de rotation correspondant à l'axe de la première poutre et le deuxième axe de rotation définie par la deuxième poutre sont confondus.

De manière préférentielle, l'ancrage de la au moins une première poutre sur la première partie et /ou la deuxième partie est situé à proximité du centre de la au moins une deuxième poutre.

La liaison mécanique peut comporter deux premières poutres et/ou deux deuxièmes poutres.

La présente invention a également pour objet une structure microélectromécanique et/ou nanoélectromécanique comportant deux parties reliées par une liaison mécanique selon l'invention.

La structure microélectromécanique et/ou nanoélectromécanique comporte avantageusement des moyens de détection du déplacement relatif des deux parties autour de l'axe de pivot.

Les moyens de détection sont par exemple formés par au moins une jauge de contrainte suspendue entre les deux parties. Deux jauges de contrainte peuvent être suspendues entre les deux parties, les deux jauges étant disposés de part et d'autre de l'axe de pivot par rapport à un plan orthogonal à un plan de la structure.

La présente invention a également pour objet un capteur inertiel comportant au moins une structure selon la présente invention, l'une des parties formant une partie fixe et l'autre formant une masse inertielle suspendue à la partie fixe par la liaison mécanique. Le capteur peut être un accéléromètre ou un magnétomètre ou un gyromètre.

La présente invention a également pour objet un micro actionneur comportant au moins une structure selon la présente invention, l'une des parties formant une partie fixe et l'autre formant une partie mobile suspendue à la partie fixe par la liaison mécanique, et des moyens de déplacement de la partie mobile par rapport à la partie fixe autour de l'axe de pivot, par exemple des moyens de type capacitif ou électrostatique, piézoélectrique, thermoélectrique, magnétique.

### BRÈVE DESCRIPTION DES DESSINS

La présente invention sera mieux comprise à l'aide de la description qui va suivre et des dessins en annexes sur lesquels :
- la figure 1 est une vue de dessus schématique d'une structure MEMS ou NEMS munie d'une liaison pivot selon un exemple d'un premier mode de réalisation de la présente invention,
- la figure 2 est une vue de dessus schématique d'une structure MEMS ou NEMS munie d'une liaison pivot selon un autre exemple du premier mode de réalisation,
- la figure 3 est une vue de dessus schématique d'une structure MEMS ou NEMS munie d'une liaison pivot selon un autre exemple du premier mode de réalisation,
- la figure 4 est une vue de dessus schématique d'une structure MEMS ou NEMS munie d'une liaison pivot selon un autre exemple du premier mode de réalisation,
- les figures 5A et 5B sont des vues de dessus d'une structure MEMS ou NEMS munie d'une liaison pivot exemplaire.

### EXPOSÉ DÉTAILLÉ DE MODES DE RÉALISATION PARTICULIERS

Dans la description qui va suivre, nous considérerons les trois directions ex, ey, ez orthogonales entre elles. Y désigne l'axe de la liaison pivot selon la présente invention, s'étendant selon la direction ey.

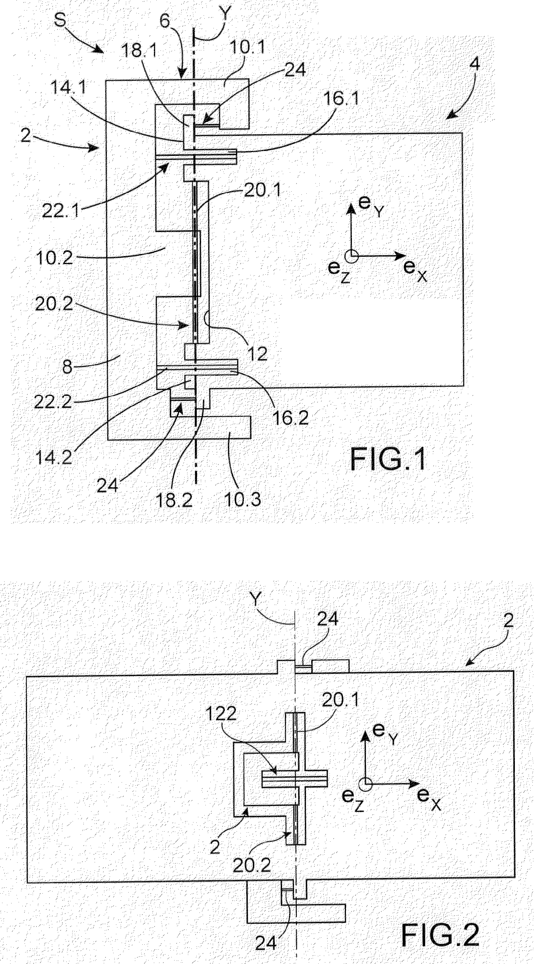

Sur la figure 1, on peut distinguer une structure S MEMS ou NEMS comportant une partie fixe 2, par exemple un substrat, une partie mobile 4 suspendue par rapport à la partie fixe 2 et une liaison pivot 6 d'axe Y reliant la partie fixe 2 et la partie mobile. L'axe Y sera désigné dans la suite de la description « axe de pivot ».

La partie fixe 2 pourrait également être elle-même mobile par rapport à une autre partie de la structure.

Dans l'exemple particulier représenté sur la figure 1, la partie fixe 2 comporte un corps principal 8 s'étendant longitudinalement sensiblement parallèlement à l'axe Y et trois branches 10.1, 10.2, 10.3 perpendiculaires au corps principal 8, de telle sorte que, vue de dessus, la partie fixe ait sensiblement la forme d'un E.

La partie mobile 4 a la forme sensiblement d'un rectangle dont un bord faisant face à la partie fixe comporte un renfoncement 12 délimité par deux portions d'extrémité 14.1, 14.2.

Les portions d'extrémité 14.1, 14.2 comporte chacune une découpe 16.1, 16.2 d'axe perpendiculaire à l'axe de pivot Y. En outre, les portions d'extrémité s'étendent chacune par une portion latérale 18.1, 18.2, ces portions latérales étant parallèles à l'axe de pivot Y.

La partie mobile est disposée par rapport à la partie fixe de sorte que la branche centrale 10.2 de la partie fixe 2 se situe entre les deux portions d'extrémité 14.1, 14.2.

Les configurations des parties fixes et des parties mobiles représentées sur la figure 1 ne sont en aucun cas limitatives et forment uniquement un exemple avantageux de structure permettant de réaliser une liaison pivot selon la présente invention optimisée.

La liaison pivot 6 comporte deux premières poutres 20.1, 20.2 alignées avec l'axe de pivot Y et reliées par chacune de leur extrémité à la partie fixe 2 et à la partie mobile 4.

Les premières poutres 20.1, 20.2 relient la branche centrale 10.2 de la partie fixe 2 aux portions d'extrémité 14.1, 14.2.

Les deux premières poutres travaillent en torsion autour de l'axe Y.

De manière générale, les poutres de torsion définissent un axe de rotation confondu avec leur axe.

La liaison pivot comporte également deux deuxièmes poutres 22.1, 22.2 disposées perpendiculairement à l'axe de pivot Y et reliant la partie fixe 2 à la partie mobile 4.

Chaque deuxième poutre 22.1, 22.2 est reliée par une extrémité longitudinale à la partie mobile dans une zone de la partie fixe 2 située entre une des branches d'extrémité 10.1, 10.3 et la branche centrale 10.2 et par une autre extrémité au fond de l'une des découpes 16.1, 16.2 de la partie mobile 4.

Les deuxièmes poutres 22.1, 22.2 travaillent en flexion.

De manière générale, les poutres de flexion définissent un axe de rotation perpendiculaire à leur axe longitudinal, la position longitudinale de l'axe de rotation dépend du type d'effort mécanique appliqué à la partie mobile.

Grâce à la forme des parties mobile et fixe de la structure représentée, l'ancrage des premières poutres 20.1, 20.2 sur les parties mobile 4 et fixe 2 est situé à proximité du centre des deux deuxièmes poutres 22.1, 22.2, l'axe de rotation défini par les premières poutres travaillant en torsion et l'axe de rotation défini par les deuxièmes poutres travaillant en flexion sont alors confondus. Dans cette configuration, la liaison pivot selon l'invention est optimisée.

Dans l'exemple représenté, la structure S MEMS ou NEMS comporte également des moyens de détection du déplacement de la partie mobile par rapport à la partie fixe 2. Dans l'exemple représenté, ces moyens de détection 24 sont formés par des jauges de contrainte; une jauge relie une zone de la partie fixe entre la branche d'extrémité 10.3 et la branche centrale 10.2 et la portion latérale 18.2, et une autre jauge relie la portion latérale 18.1 de la partie mobile à une extrémité de la branche d'extrémité 10.1. Les deux jauges sont disposées chacune d'un côté et de l'autre de l'axe de pivot Y par rapport à un plan orthogonal au plan de la structure.

Les jauges travaillent en compression selon leur axe principal. Les jauges de contrainte peuvent par exemple être du type jauge piézorésistive, jauge de contrainte résonante (la fréquence de résonance d'un mode de déformation transverse dépend de la contrainte longitudinale)... A titre d'exemple, nous allons donner des exemples de dimensions des poutres et des jauges de contrainte. La ou les poutres de flexion a ou ont une longueur comprise entre 5 µm et 1000 µm, une largeur comprise entre 0,1 µm et 100 µm, et une épaisseur comprise entre 1 µm et 100 µm. par exemple, la ou les poutres a (ont) une longueur de 50µm, une largeur de 1 µm et une épaisseur de 10 µm.

La ou les poutres de torsion a ou ont une longueur comprise entre 1 µm et 1000 µm, une largeur comprise entre 0,1 µm et 100 µm et une épaisseur comprise entre 1 µm et 100 µm. par exemple, la ou les poutres a (ont) une longueur de 25 µm, une largeur de 1 µm et une épaisseur de 10 µm.

La ou les jauges de contrainte a ou ont une longueur comprise entre 0,1 µm et 200 µm, une largeur comprise entre 0,01 µm et 50 µm, et une épaisseur comprise entre 0,01 µm et 50 µm. Par exemple, la ou les jauges de contrainte a (ont) une longueur de 5 µm, une largeur de 0,25 µm et une épaisseur de 0,25 µm.

Une liaison pivot dans laquelle les axes de rotation définis par les premières poutres et les deuxièmes poutres respectivement sont décalés, tout en restant parallèles, ne sort pas du cadre de la présente invention, la rotation autour de la liaison pivot est alors autorisée grâce aux autres degrés de libertés des deux liaisons en rotation combinées, ces liaisons étant formées par la ou les poutres travaillant en flexion et la ou les poutres travaillant en torsion. L'efficacité d'une telle liaison pivot est réduite par rapport à une liaison pivot dans laquelle les axes de rotation sont confondus. Cependant elle offre une raideur accrue par rapport aux liaisons pivots de l'état de la technique. Une structure similaire à celle de la figure 1 dans laquelle la partie mobile 4 ne comporterait pas de découpes 16.1, 16.2, les deuxièmes poutres 22.1, 22.2 étant alors fixées directement sur les bords des portions d'extrémité 14.1, 14.2 présenterait des axes de rotation des premières poutres et des deuxièmes poutres non confondus.

Le décalage des axes de rotation défini pour chaque type de poutre (flexion ou torsion) se situe de préférence dans une gamme à l'intérieur de laquelle l'angle de rotation de la partie mobile 2 par rapport à la partie fixe 4 obtenu avec la liaison selon l'invention est supérieur à 1% du minimum des angles de rotation que l'on obtiendrait en ne conservant qu'une seul type de poutre pour un même effort mécanique exercé en l'absence de jauges de contrainte en considérant soit la présence soit l'absence de jauges de contrainte.

La structure équipée d'une liaison pivot selon la présente invention présente une forte raideur selon la direction eₓ et une forte résistance au choc selon la direction eₓ. En effet, les deuxièmes poutres 22.1, 22.2 travaillant en flexion confèrent au système une raideur importante selon la direction ex. Les jauges 24 sont ainsi protégées par les bras de flexion en cas de choc selon la direction ex ou de tout type d'effort présentant une composante de force selon la direction ex. En l'absence de jauges, l'amplitude des mouvements résultant est fortement atténuée.

La structure selon la présente invention offre également une forte raideur selon la direction ey et une forte résistance au choc selon la direction ey. En effet, les poutres de torsion confèrent au système une raideur importante selon la direction ey.

Les jauges 24, qui présentent une raideur plus faible selon cette même direction, sont ainsi protégées des effets de la composante de force selon la direction ey générée par exemple en cas de choc selon la direction ey. En l'absence de jauges, l'amplitude des mouvements résultant de cette composante de force est fortement atténuée.

Enfin, la structure offre une forte raideur de torsion autour de la direction ez et une force résistance à des moments de forte intensité en O, O étant situé sur la branche centrale 10.2 de la partie fixe. En effet, les deuxièmes poutres selon la direction ex peuvent s'opposer à un mouvement de rotation selon la direction ez grâce à leur grande raideur longitudinale. Il est à noter que la raideur de torsion autour de e_{z} est d'autant plus importante que les poutres sont éloignées l'une de l'autre Cette propriété peut permettre de limiter les efforts supportés par les jauges. En l'absence de jauges, l'amplitude des mouvements résultant est fortement atténuée.

Sur la figure 2, on peut voir un autre exemple de réalisation d'une structure dans laquelle la liaison pivot comporte deux premières poutres 20.1, 20.2 travaillant en torsion et une deuxième poutre 122 travaillant en flexion. Cette dernière est disposée entre les deux premières poutres 20.1, 20.2. Dans l'exemple représenté, la masse mobile 4 s'étend de part et d'autre de l'axe pivot Y, de sorte que son centre d'inertie soit sur l'axe du pivot Y. cette structure comporte également des jauges de contraintes connectés entre deux saillies latérales 18.1, 18.2 de la masse mobile 4 et la partie fixe. De manière avantageuse, l'axe de torsion des premières poutres 20.1, 20.2 croise la deuxième poutre 122 en son milieu.

Cette structure présente l'avantage de bloquer le mouvement de translation selon la direction e_{Y} et selon la direction e_{X}. De plus les mouvements de rotation autour des directions e_{X} et e_{Z} sont d'autant plus bloqués que les poutres de torsion 20.1, 20.2 sont éloignées l'une de l'autre.

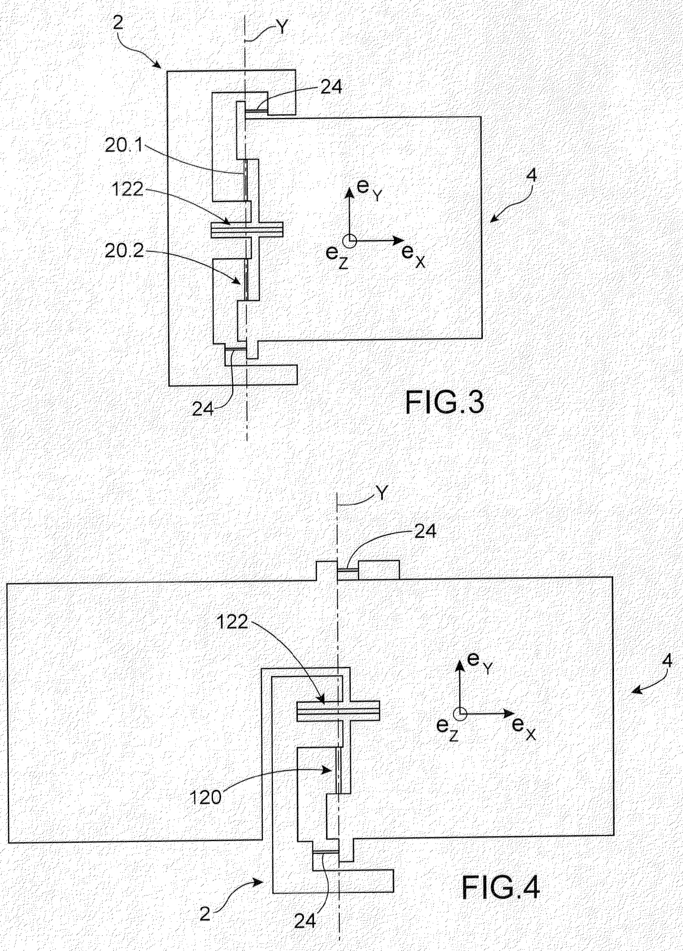

Sur la figure 3, on peut voir un autre exemple de réalisation de structure proche de celle de la figure 2, celle-ci diffère de celle de la figure 2 en ce que le centre d'inertie est déporté hors d e l'axe du pivot Y. Pour cela l'axe du pivot de la masse mobile 4 est situé sur un bord de la masse mobile 4. De manière avantageuse, l'axe de torsion des premières poutres 20.1, 20.2 croise la deuxième poutre 122 en son milieu.

Sur la figure 4, on peut voir un autre exemple de réalisation d'une structure comportant une première poutre 120 travaillant en torsion et une deuxième poutre 122 travaillant en flexion. Dans cette structure la partie mobile 4 s'étend de part et d'autre de l'axe du pivot Y. Cette structure comporte également des jauges de contraintes connectées entre deux saillies latérales 18.1, 18.2 de la masse mobile 4 et la partie fixe. De manière avantageuse, l'axe de torsion de la première poutre 120 croise la deuxième poutre 122 en son milieu.

Cette structure présente l'avantage de bloquer le mouvement de translation selon la direction e_{Y} et selon la direction e_{X}. De plus les mouvements de rotation autour des directions e_{X} et e_{Z} sont d'autant plus bloqués que la poutre de torsion 120 et la poutre de flexion 122 sont éloignées l'une de l'autre.

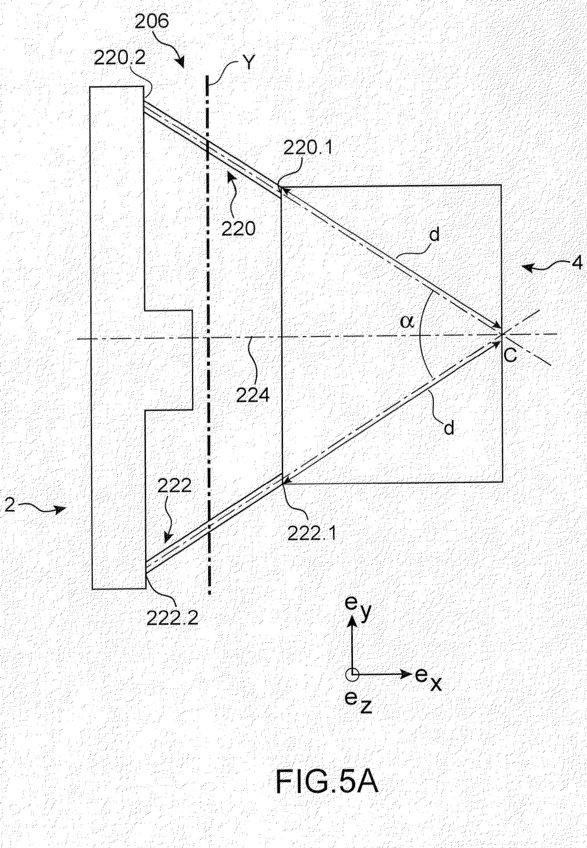

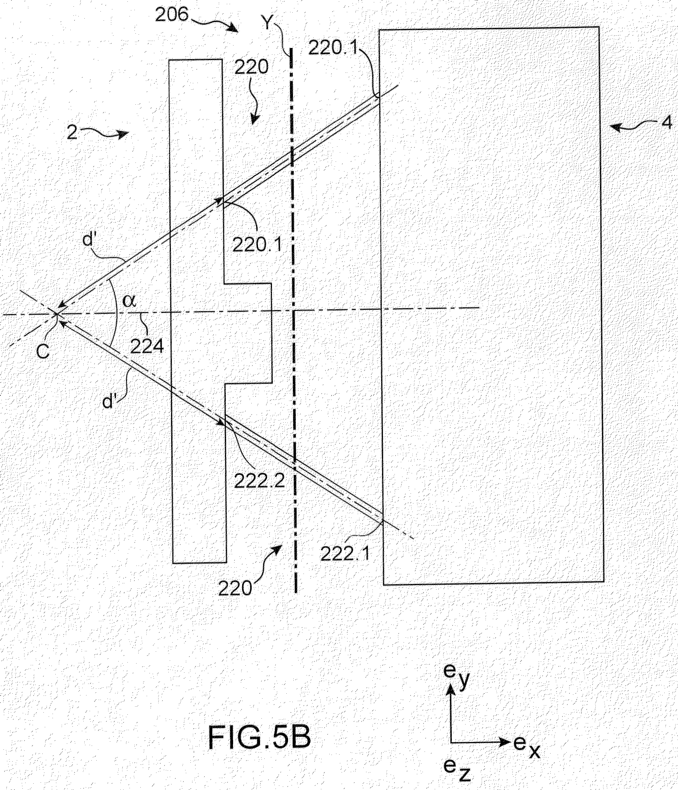

Comme l'illustrent les figures 1 à 4, La liaison pivot peut comporter une, deux ou plus de deux premières poutres travaillant en torsion et une, deux ou plus de deux poutres travaillant en flexion sans sortir du cadre Sur les figures 5A et 5B, on peut voir un autre mode de réalisation d'une liaison mécanique dans laquelle les axes des deux poutres ne sont pas nécessairement orthogonaux.

Sur la figure 5A, la liaison mécanique 206 présente un axe pivot Y entre la partie 2 et la partie 4. Dans l'exemple représenté, la liaison mécanique comporte une première poutre 220 et une deuxième poutre 222 de suspension s'étendant entre la partie 2 et la partie 4 dont les axes sont sécants en un point C. Dans l'exemple de la figure 5A, le point C est situé sur la partie 4. Mais ceci n'est en aucun cas limitatif, le point C pourrait se situer en dehors de la partie 4; sur la figure 5B, le point C est situé en dehors de la partie 2.

Dans l'exemple représenté sur la figure 5A, les poutres 220, 222 sont ancrées sur la partie 4 au niveau de leur extrémité 220.2, 222.2 respectivement au niveau de deux sommets de la partie 4.

Les poutres 220, 222 travaillent à la fois en flexion et en torsion, elles définissent l'axe pivot Y résultant qui est perpendiculaire à la bissectrice 224 de l'angle α défini par les deux axes des poutres 220, 222. L'axe pivot Y passe au voisinage du milieu des première 220 et deuxième 222 poutres.

L'angle α est compris dans l'intervalle ]0°; 180[, de sorte que les axes des deux poutres 220, 222 ne sont pas parallèles. De préférence, α est compris entre 20° et 160°. Ainsi la liaison mécanique présente les caractéristiques de raideur recherchées. Par exemple dans le cas où α est égale à 20° ou 160° et les poutres 220 et 222 sont identiques, la raideur en translation, quel que soit l'axe considéré dans le plan des poutres, est au moins égale à 12% de la raideur en translation maximale dans ce même plan. Alors que, dans une liaison mécanique formant pivot de l'état de la technique dans laquelle l'axe de pivot est formé par une ou des poutres sollicitées en torsion ou en flexion, cette raideur en translation est de l'ordre de 1% à la raideur en translation maximale dans ce même plan. Ainsi grâce à ce mode de réalisation, la liaison mécanique présente une raideur en translation augmentée quel que soit l'axe considéré dans le plan des poutres.

Dans un exemple préféré, l'angle α est avantageusement égal à 90°.

Dans ce cas, la raideur en translation de la liaison pivot est identique quelle que soit la direction considérée dans le plan des poutres.

La raideur en rotation selon les deux autres axes perpendiculaires à celui de l'axe de rotation recherché est d'autant plus importante que les deux poutres sont éloignées de leur point d'intersection. Par exemple, la distance d entre le point d'intersection C et le point d'ancrage 220.1, de la poutre 220 sur la partie 4 est choisie égale à au moins une fois la demi-longueur des poutres, ainsi que celle entre le point d'intersection C et le point d'ancrage 222.1 de la poutre 222 sur la partie 4.

De manière préférée, le point d'intersection C est confondu avec le centre d'inertie de la partie mobile 4 ou se situe au voisinage de celui-ci.

Sur l'exemple de réalisation de la figure 5B, le point d'intersection C des axes des première et deuxième poutres est situé du côté de la partie 2 en dehors de la partie mobile 2. De préférence, l'angle α est égale à 90° et de manière préférée, le point C est confondu avec le centre d'inertie de la partie mobile 2. Comme pour l'exemple de la figure 5A, la distance d' entre le point d'intersection C et le point d'ancrage 222.1, de la poutre 220, sur la partie 2 est choisie égale à au moins une fois la demi-longueur des poutres, ainsi que celle entre le point d'intersection C et le point d'ancrage 222.2 de la poutre 222 sur la partie 2.

De manière préférée, les poutres sont de longueur et de dimensions proches ou identiques. Il sera compris, cependant, qu'une liaison mécanique dans laquelle les deux poutres sont de longueurs différentes et/ou de sections différentes et/ou de formes différentes ne sort pas du cadre de la présente invention

Par ailleurs, la liaison mécanique peut comporter plus de deux poutres sécantes en un point. Par exemple, la liaison mécanique peut comporter trois poutres, deux poutres par exemple disposées comme sur les figures 5A et 5B et une poutre s'étendant le long de la bissectrice de l'angle délimité par les deux poutres et ancrée sur les parties 2 et 4. Selon un autre exemple, elle peut comporter quatre poutres. En partant de la liaison des figures 5A et 5B comportant les première et deuxième poutres, celle-ci comporterait en plus une paire de troisième et quatrième poutres réparties symétriquement de sorte que la bissectrice de l'angle qu'elles définissent soit confondue avec celle de l'angle défini par les première et deuxième poutres. Une telle liaison mécanique serait en fait la combinaison de deux liaisons mécaniques à deux poutres.

Les axes de pivot définit par ces deux liaisons peuvent être confondus ou non, l'axe de pivot de la liaison mécanique résultant de ces deux axes.

Cette liaison mécanique selon ce deuxième mode de réalisation permet de réaliser une liaison pivot, entre les deux parties, robustes aux perturbations mécaniques qui bénéficie de caractéristiques mécaniques similaires à celles du premier mode de réalisation, i.e. des raideurs en translation importantes selon les trois axes et des raideurs en torsion importantes selon les deux autres axes complémentaires, une résistance au choc, et qui assure une protection des nanojauges.

La structure MEMS ou NEMS selon la présente invention peut être fabriquée avec les techniques classiques de la micro et nanoélectronique, avec des étapes de dépôt de couches, de lithographie et de gravure. Lors de la réalisation d'une structure selon la présente invention, et plus particulièrement de la liaison pivot, les axes de rotation de chacune des premières et deuxièmes poutres sont déterminés. Pour cela, les poutres de liaison de l'autre type ne sont pas prises en compte lors du calcul du comportement mécanique de la structure. La configuration particulièrement avantageuse de l'exemple de réalisation représenté sur la figure 1 est obtenue lorsque les deux calculs pour chaque type de poutres fournissent le même axe de rotation.

La liaison pivot selon la présente invention peut être appliquée à l'ensemble des structures MEMS-NEMS présentant un mouvement de rotation d'un de leurs éléments mécaniques. Les domaines d'application concernent en particulier les accéléromètres, les gyromètres, les magnétomètres, les commutateurs RF et les micro-actionneurs, tels que les micro-miroirs, les micro capteurs, etc.

Son intégration dans les structures MEMS et NEMS existantes est simple et n'impose de modifications importantes de leur procédé de réalisation, par conséquent le coût de fabrication des structures MEMS et NEMS selon l'invention par rapport à celles de l'état de la technique n'est pas augmenté.

## Revendications

1. Structure microélectromécanique et/ou nanoélectromécanique comportant deux parties (2, 4) et une liaison mécanique (6) reliant les deux parties, la liaison mécanique formant un pivot d'axe de rotation (Y) et comportant au moins une première poutre (20.1, 20.2, 120) disposée parallèlement à l'axe de pivot (Y), ladite première poutre étant destinée à travailler en torsion, et au moins une deuxième poutre (22.1, 22.2, 122) d'axe orthogonal à l'axe de la première poutre, chacune des première (20.1, 20.2, 120) et deuxième (22.1, 22.2, 122) poutres étant reliées au niveau de leurs extrémités aux deux parties (2, 4) de la structure de sorte à permettre auxdites parties de se déplacer en rotation selon ledit axe pivot et à éviter auxdites parties de se déplacer en translation selon cet axe, dans laquelle la première poutre (20.1, 20.2, 120) travaille en torsion selon un premier axe de rotation et
**caractérisée en ce que** la deuxième poutre (22.1, 22.2, 122) travaille en flexion définissant un deuxième axe de rotation, et dans laquelle l'axe pivot de ladite liaison mécanique résulte du premier axe et du deuxième axe et est parallèle aux premier et deuxième axes.

2. Structure microélectromécanique et/ou nanoélectromécanique selon la revendication 1, dans laquelle chacune des première (20.1, 20.2, 120) et deuxième (22.1, 22.2, 122) poutres sont reliées au niveau de leurs extrémités aux deux parties (2, 4) de la structure de sorte à éviter auxdites parties de se déplacer en rotation en dehors dudit axe pivot.

3. Structure microélectromécanique et/ou nanoélectromécanique selon la revendication 1 ou 2, dans laquelle le premier axe de rotation correspondant à l'axe de la première poutre (20.1, 20.2, 120) et le deuxième axe de rotation définie par la deuxième poutre (22.1, 22.2, 122) sont confondus.

4. Structure microélectromécanique et/ou nanoélectromécanique selon l'une des revendications 1 à 3, dans laquelle l'ancrage de la au moins première poutre sur la première partie et/ou la deuxième partie est tel que l'axe longitudinal de la au moins première poutre est sécant avec l'axe longitudinal de la au moins deuxième poutre sensiblement en son milieu.

5. Structure microélectromécanique et/ou nanoélectromécanique selon l'une des revendications 1 à 4, comportant deux premières poutres (20.1, 20.2) et/ou deux deuxièmes poutres (22.1, 22.2).

6. Structure microélectromécanique et/ou nanoélectromécanique selon l'une des revendications 1 à 5, comportant des moyens de détection (24) du déplacement relatif des deux parties (2. 4) autour de l'axe de pivot (Y).

7. Structure microélectromécanique et/ou nanoélectromécanique selon la revendication 6, dans laquelle les moyens de détection (24) sont formés par au moins une jauge de contrainte suspendue entre les deux parties (2, 4), avantageusement les moyens de détection (24) comportant deux jauges de contrainte suspendues entre les deux parties (2, 4), les deux jauges étant disposées de part et d'autre de l'axe de pivot (Y) par rapport à un plan orthogonal à un plan de la structure.

8. Capteur inertiel comportant au moins une structure selon la revendication 6 ou 7, l'une des parties (2) formant une partie fixe et l'autre (4) formant une masse inertielle suspendue à la partie fixe par la liaison mécanique (6).

9. Capteur inertiel selon la revendication 8 formant un accéléromètre ou un magnétomètre ou un gyromètre.

10. Micro actionneur comportant au moins une structure selon l'une des revendications 1 à 7, l'une des parties (2) formant une partie fixe et l'autre (4) formant une partie mobile suspendue à la partie fixe (2) par la liaison mécanique (6), et des moyens de déplacement de la partie mobile par rapport à la partie fixe autour de l'axe de pivot, par exemple des moyens de type capacitif ou électrostatique, piézoélectrique, thermoélectrique, magnétique.

## Patentansprüche

1. Mikroelektromechanische und/oder nanoelektromechanische Struktur, umfassend zwei Teile (2, 4) und eine mechanische Verbindung (6), welche die beiden Teile verbindet, wobei die mechanische Verbindung eine Rotations-Schwenkachse (Y) bildet, und umfassend wenigstens einen ersten Träger (20.1, 20.2, 120), welcher parallel zu der Schwenkachse (Y) angeordnet ist, wobei der erste Träger dazu vorgesehen ist, unter Torsion zu arbeiten, sowie wenigstens einen zweiten Träger (22.1, 22.2, 122) mit einer Achse orthogonal zu der Achse des ersten Trägers, wobei jeder der ersten (20.1, 20.2, 120) und zweiten (22.1, 22.2, 122) Träger auf dem Niveau ihrer Enden mit den beiden Teilen (2, 4) der Struktur verbunden sind, so dass den Teilen erlaubt wird, sich in Rotation um die Schwenkachse zu verlagern, und verhindert wird, dass sich die Teile in Translation entlang der Achse verlagern, wobei der erste Träger (20.1, 20.2, 120) unter Torsion gemäß einer ersten Rotationsachse arbeitet, und **dadurch gekennzeichnet, dass** der zweite Träger (22.1, 22.2, 122) unter Biegung arbeitet, wobei eine zweite Rotationsachse definiert wird, und wobei die Schwenkachse der mechanischen Verbindung aus der ersten Achse und der zweiten Achse resultiert und parallel zu den ersten und zweiten Achsen ist.

2. Mikroelektromechanische und/oder nanoelektromechanische Struktur nach Anspruch 1, wobei jeder aus den ersten (20.1, 20.2, 120) und den zweiten (22.1, 22.2, 122) Trägern auf dem Niveau ihrer Enden mit den beiden Teilen (2, 4) der Struktur derart verbunden sind, dass verhindert wird, dass die Teile sich in Rotation außerhalb der Schwenkachse verlagern.

3. Mikroelektromechanische und/oder nanoelektromechanische Struktur nach Anspruch 1 oder 2, wobei die erste Rotationsachse, welche der Achse des ersten Trägers (20.1, 20.2, 120) entspricht, und die zweite Rotationsachse, welche durch den zweiten Träger (22.1, 22.2, 122) definiert ist, zusammenfallend sind.

4. Mikroelektromechanische und/oder nanoelektromechanische Struktur nach einem der Ansprüche 1 bis 3, wobei die Verankerung des wenigstens einen ersten Trägers an dem ersten Teil und/oder dem zweiten Teil derart ist, dass die longitudinale Achse des wenigstens einen ersten Trägers die longitudinale Achse des wenigstens einen zweiten Trägers im Wesentlichen in seiner Mitte schneidet.

5. Mikroelektromechanische und/oder nanoelektromechanische Struktur nach einem der Ansprüche 1 bis 4, umfassend zwei erste Träger (20.1, 20.2) und/oder zwei zweite Träger (22.1, 22.2).

6. Mikroelektromechanische und/oder nanoelektromechanische Struktur nach einem der Ansprüche 1 bis 5, umfassend Mittel zum Detektieren (24) der relativen Verlagerung der beiden Teile (2, 4) um die Schwenkachse (Y).

7. Mikroelektromechanische und/oder nanoelektromechanische Struktur nach Anspruch 6, wobei die Mittel zum Detektieren (24) durch wenigstens einen Dehnungsmessstreifen (24) gebildet sind, welcher zwischen den beiden Teilen (2, 4) aufgehängt ist, wobei vorzugsweise die Mittel zum Detektieren (24) zwei Dehnungsmessstreifen umfassen, welche zwischen den beiden Teilen (2, 4) aufgehängt sind, wobei die beiden Messstreifen beiderseits der Schwenkachse (Y) bezüglich einer Ebene orthogonal zu einer Ebene der Struktur angeordnet sind.

8. Trägheitssensor, umfassend wenigstens eine Struktur nach einem der Ansprüche 6 oder 7, wobei einer der beiden Teile (2) einen festen Teil bildet und der andere (4) eine träge Masse bildet, welche an dem festen Teil durch die mechanische Verbindung (6) angebracht ist.

9. Trägheitssensor nach Anspruch 8, einen Beschleunigungssensor oder ein Magnetometer oder ein Gyrometer bildend.

10. Mikro-Stellantrieb, umfassend wenigstens eine Struktur nach einem der Ansprüche 1 bis 7, wobei der eine der Teile (2) einen festen Teil bildet und der andere (4) einen beweglichen Teil bildet, welcher an dem festen Teil (2) durch die mechanische Verbindung (6) aufgehängt ist, sowie Mittel zum Verlagern des beweglichen Teils bezüglich dem festen Teil um die Schwenkachse herum, beispielsweise Mittel vom kapazitiven oder elektrostatischen, piezoelektrischen, thermoelektrischen, magnetischen Typ.

## Claims

1. A microelectromechanical and/or nanoelectromechanical structure comprising two parts (2, 4) and a mechanical connection (6) connected the twoparts, the mechanical connection forming a pivot with an axis of rotation (Y) comprising at least one first beam (20.1, 20.2, 120) provided in parallel to the pivot axis (Y), said first beam being configured to work in torsion, and at least one second beam (22.1, 22.2, 122), with an axis orthogonal to the axis of the first beam, , each one of the first (20.1, 20.2, 120) and second (22.1, 22.2, 122) beams being connected at theirs ends to the two parts (2, 4) of the structure so as to enable said parts to be rotationally displaced along said pivot axis and prevent said parts from being translationally displaced along this axis, wherein the first beam (20.1, 20.2, 120) works in torsion along a first axis of rotation **characterized in that** the second beam (22.1, 22.2, 122) works in bending defining a second axis of rotation, and wherein the pivot axis of said mechanical connection results from the first axis and the second axis and is parallel to the first and second axes.

2. The microelectromechanical and/or nanoelectromechanical structure according to claim 1, wherein each one of the first (20.1, 20.2, 120) and second (22.1, 22.2, 122) beams are connected at theirs ends to the two parts (2, 4) of the structure so as to prevent said parts from being rotationally displaced off said pivot axis.

3. The microelectromechanical and/or nanoelectromechanical structure according to claim 1 or 2, wherein the first axis of rotation corresponding to the axis of the first beam (20.1, 20.2, 120) and the second axis of rotation defined by the second beam (22.1, 22.2, 122) are coincident.

4. The microelectromechanical and/or nanoelectromechanical structure according to one of claims 1 to 3, wherein the anchoring of the at least one first beam to the first part and/or the second part is such that the longitudinal axis of the at least one first beam is intersecting the longitudinal axis of the at least one second beam substantially at its middle.

5. The microelectromechanical and/or nanoelectromechanical structure according to one of claims 1 to 4, comprising two first beams (20.1, 20.2) and/or two second beams (22.1, 22.1).

6. The microelectromechanical and/or nanoelectromechanical structure according to one of claims 1 to 5, comprising means (24) for detecting the relative displacement of both parts (2, 4) about the pivot axis (Y).

7. The microelectromechanical and/or nanoelectromechanical structure according to claim 6, wherein the detection means (24) are formed by at least one strain gauge suspended between both parts (2, 4), the detection beam advantageously comprising two strain gauges suspended between both parts (2, 4), both gauges being provided on either side of the pivot axis (Y) with respect to a plane orthogonal to a plane of the structure.

8. An inertial sensor comprising at least one structure according to claim 6 or 7, wherein one of the parts (2) forms a fixed part and the other (4) forms an inertial mass suspended to the fixed part by the mechanical connection (6).

9. The inertial sensor according to claim 8, forming an accelerometer or a magnetometer or a gyrometer.

10. A microactuator comprising at least one structure according to one of claims 1 to 7, wherein one of the parts (2) forms a fixed part and the other (4) forms a movable part suspended to the fixed part (2) by the mechanical connection (6), and means for displacing the movable part (2) with respect to the fixed part about the pivot axis, for example capacitive or electrostatic, piezoelectric, thermoelectric or magnetic type means.
